# EUROPEAN PATENT APPLICATION

(11) **EP 2 584 437 A2**
(43) Date of publication of application: **24.04.2013**
(21) Application number: 11795973.4
(22) Date of filing: 16.06.2011
(51) Int. Cl.: G06F 3/041

(54) **TOUCH PANEL SENSOR**

(30) Priority: 25.02.2011 KR 20110017076; 10.12.2010 KR 20100126158; 05.10.2010 KR 20100097016; 16.06.2010 KR 20100057279
(71) Applicant: Samwon St, Bupyeong-gu, Incheon 403-130 (KR)
(72) Inventor: NAHM, Dong Sik, Hwaseong-si Gyeonggi-do 445-757 (KR); PARK, Chul, Seongnam-si Gyeonggi-do 463-752 (KR)
(74) Representative: Rupprecht, Kay
(86) International application number: PCT/KR2011/004406
(87) International publication number: WO 2011/159107

(57) **Abstract**

A touch panel sensor for sensing a contact position of a target object may include an insulating substrate, electrode patterns formed on the bottom surface of the insulating substrate and for sensing the target object accessing thereto, a window decoration provided on the bottom surface of the insulating substrate in order to block light and including penetration regions through which the respective ends of the electrode patterns are exposed, coloration conduction layers provided in the respective penetration regions in order to block light and electrically connected to the electrode patterns, and wire members electrically connected to the ends of the electrode patterns disposed in the penetration regions through a medium of the coloration conduction layers.

## Description

### [Technical Field]

The present invention relates to a touch panel sensor, and more particularly, to a touch panel sensor for detecting the contact position of a target object.

### [Background Art]

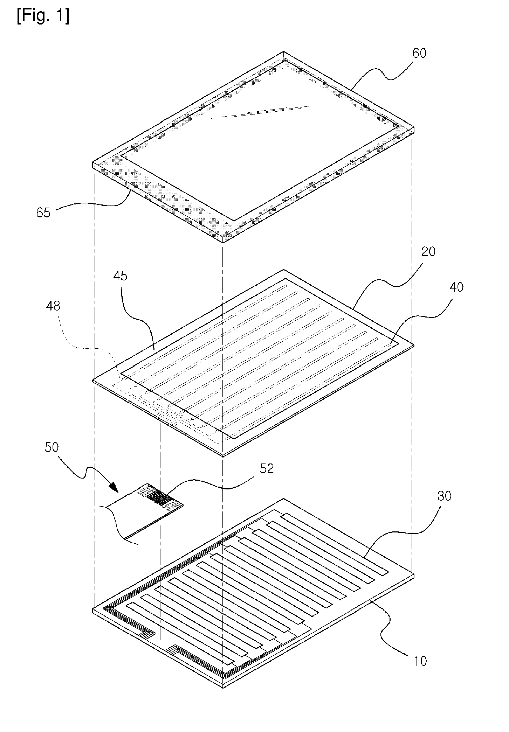

FIG. 1 is a perspective view illustrating a conventional touch panel sensor of a capacitive method.

Referring to FIG. 1, the conventional touch panel sensor 1 includes a lower insulating sheet 10 and an upper insulating sheet 20 which are spaced apart at a specific interval and joined together. Lower ITO electrodes 30 and upper ITO electrodes 40 are vertically arranged on the respective surfaces of the lower insulating sheet 10 and the upper insulating sheet 20 which face ach other. More particularly, the lower ITO electrodes 30 are oriented on a top surface of the lower insulating sheet 10 from the left to the right, and the upper ITO electrodes 40 are oriented on a bottom surface of the upper insulating sheet 20 from the top to the bottom.

In the aforementioned touch panel sensor 1, there is specific capacitance corresponding to the area of each intersection point, that is, a capacitance value, at each of the intersection points of the lower ITO electrodes(30) and the upper ITO electrodes(40) that are arranged to intersect each other. When part of the body approaches the sensor, the capacitance value can be changed because the area of part of the human body is added to the area of the upper ITO electrodes(40) disposed on the upper side.

Furthermore, in order to electrically couple the upper ITO electrodes 40 and the electrode 52 of an external circuit board 50, connection lines 48 made of metal are extended from the ends of the upper ITO electrodes 40 to a lower part of the upper insulating sheet 20, and the lower ITO electrodes(30) are also connected to the circuit board 50 by additional connection lines.

In general, the connection lines 48 made of metal can be seen by the naked eye on the upper side of the transparent upper insulating sheet 20 because the connection lines 48 glitter due to metal glass and do not transmit light. In the prior art, an additional non-transparent film 65 for a window decoration is formed on the bottom of a tempered substrate 60, such as additional glass or transparent reinforced plastic, so that the connection lines 48 and the circuit board 50 are seen by the naked eye and the tempered substrate 60 is disposed over the upper insulating sheet 20.

However, if the aforementioned non-transparent film 65 is attached on the bottom of the tempered substrate 60, a defect can occur because the aforementioned non-transparent film 65 can be easily deviated from an attachment process and the degree of difficulty of the process can be increased because the attachment process itself is inconvenience.

Furthermore, if the tempered substrate 60 is further provided over the upper insulating sheet 20 in order to protect a surface of the upper insulating sheet 20, there are disadvantages in that the thickness of the touch panel sensor is increased and an assembly process is complicated.

Moreover, an increase in the thickness of the touch panel sensor can be a factor leading to a decrease in the transparency and sharpness of the touch panel sensor and may deteriorate the sensitivity of the touch panel sensor.

### [Disclosure]

### [Technical Problem]

The present invention provides a touch panel sensor which can minimize a possibility that upper ITO electrode provided on the bottom of an upper insulating sheet can be broken by the bending of the upper insulating sheet that is generated by a user's touch or an external shock.

The present invention provides a touch panel sensor for preventing connection lines for electrically coupling upper ITO electrodes disposed in an upper insulating sheet and an external circuit board and the circuit board from being seen by the naked eye.

### [Technical Solution]

In accordance with an exemplary embodiment of the present invention, a touch panel sensor for sensing the contact position of a target object may include an insulating substrate, electrode patterns formed on the bottom surface of the insulating substrate and for sensing the target object accessing thereto, a window decoration provided on the bottom surface of the insulating substrate in order to block light and including penetration regions through which the respective ends of the electrode patterns are exposed, coloration conduction layers provided in the respective penetration regions in order to block light and electrically connected to the electrode patterns, and wire members electrically connected to the ends of the electrode patterns disposed in the penetration regions through a medium of the coloration conduction layers.

Furthermore, if the insulating substrate is part of an upper insulating substrate, a lower sheet for sensing part of the body accessing thereto through an interaction with upper electrode patterns can be provided on the bottom of the upper insulating substrate. The transparent or opaque electrode pattern applied to the insulating substrate can be used to sense the contact position of a target object and can be formed using a capacitive method or a resistance film method.

In the present invention, the upper insulating substrate can be made of material having a high surface strength and can be fabricated using glass or plastic material that transmits light like glass or glass and has an excellent surface strength. Likewise, the lower insulating substrate in which the lower transparent electrode patterns that interact with the upper transparent electrode patterns in the lower sheet are disposed can be fabricated using the same material as the upper insulating substrate.

Furthermore, the upper electrode pattern or the lower electrode pattern can be made of Indium Tin Oxide (ITO) or Indium Zinc Oxide (IZO) having both transparency and conductivity. The electrode pattern may be made of an opaque conductive material according to circumstances. For example, various pieces of metal or a variety of alloys, such as gold, silver, and aluminum having a smaller resistance coefficient than ITO and IZO, can be used. If the opaque conductive material is used as the material of the electrode pattern, however, the opaque conductive material must be thin enough so that an image of a display module is exposed without being covered. More particularly, if the width of the electrode pattern made of an opaque material exceeds 0 to 30 *µ*m or less, the electrode pattern is rarely seen by the naked eye. Accordingly, the electrode pattern is not visible to the outside, and thus an image of a display module, such as a liquid crystal display disposed on the bottom of the touch panel sensor, can be exposed without being covered.

Here, wire members electrically connected to the ends of the upper electrode patterns can be disposed at the edge of one side of the upper insulating substrate in order to couple respective coloration conduction layers and an external circuit board. The wire member is provided as a conductive connection pattern made of non-transparent metal and thus can be visible to the outside. Accordingly, a window decoration of a frame form is provided in the circumferential region of the upper insulating substrate in which the wire member is disposed.

In this specification, the term 'wire member' can become a conductive connection pattern formed on the window decoration and made of metal. The conductive connection pattern and the window decoration can be fabricated by silkscreen, gravia printing, etc. using the existing silver paste. In some embodiments, the conductive connection pattern and the window decoration can be fabricated by various methods, such as a process through metal deposition and etching, nano-imprinting, and ink-jet print. In addition, the wire member may not be directly formed on the window decoration, but may function to indirectly connect an electrical terminal using a flexible circuit board.

Here, consideration may be taken of that the end of the upper electrode pattern is formed on the bottom of the window decoration and the conductive connection pattern is formed on the bottom of the window decoration. In this case, the upper electrode pattern can be bent at a boundary portion at which the upper electrode pattern meets the window decoration, which can deteriorate durability.

Accordingly, in the touch panel sensor in accordance with the present invention, the penetration region can be formed near the end of each of the upper electrode patterns in the insulating window decoration and the ends of the upper electrode patterns can be disposed in the penetration region, so that the upper electrode patterns are generally formed on the bottom of the upper insulating substrate without bending.

The coloration conduction layers are provided in the aforementioned penetration regions and configured to prevent the inside of the touch panel sensor from being exposed through the penetration regions by blocking light. The coloration conduction layer can be formed using any one of methods, such as coating, printing, silkscreen, ink-jet, deposition, pad printing, and masking.

For reference, the coloration conduction layers preferably have a color that is in harmony with the window decoration. Here, the meaning 'harmony' may include that the coloration conduction layers and the window decoration are not visually distinguished from each other externally because the coloration conduction layers visible to the outside have the same color as the window decoration and that the coloration conduction layers do not have the same color as the window decoration, but the coloration conduction layers are visually distinguished from the window decoration when being seen on the outside, thus being capable of displaying a specific design and pattern, acceding to circumstances.

By forming the conductive connection patterns under the aforementioned coloration conduction layers, the ends of the upper electrode patterns and the conductive connection patterns disposed in the penetration regions can be electrically coupled and also the coloration conduction layers can prevent the opaque conductive connection patterns from being exposed to the outside.

The coloration conduction layer can be made of material including a conductive material, such as carbon, and the coloration conduction layer can include conductive transparent ink provided in the penetration region so that the coloration conduction layer is electrically connected to the electrode pattern acceding to circumstances. The conductive transparent ink can be provided so that it includes at least any one of polyethylenedioxythiophene (PEDOT), ITO, IZO, and carbon nanotube (CNT). Furthermore, the coloration conduction layer can include non-conductive coloring ink having a color corresponding to the window decoration. It is possible to easily control the entire color of the coloration conduction layer like that of the window decoration using coloring ink, and the color of the coloration conduction layer can be easily matched with that of the window decoration using coloring ink because the aforementioned conductive transparent ink is also transparent. For example, if the window decoration is a black-based color, black dyes can be used as the coloring ink. If the window decoration is a white-based color, white dyes can be used as the coloring ink. Here, either a conductive material or a non-conductive material can be used as the coloring ink.

Furthermore, in another exemplary embodiment of the present invention, each of the coloration conduction layers includes a plurality of individual membranes vertically piled. Each of the individual membranes can have a different mixing ratio of the conductive material and the non-conductive coloring material.

The aforementioned coloration conduction layers can prevent the inside of the touch panel sensor from being exposed through the penetration regions by blocking light in the penetration regions. In the present invention, each of the coloration conduction layers includes the plurality of individual stacked membranes. The ratio of the non-conductive coloring material to the conductive material included in the individual membrane can be gradually increased toward the top surface of the insulating substrate. Thus, as the ratio of the non-conductive coloring material that can be provided as a use for harmonizing the color of the window decoration with the coloration conduction layer is increased, the individual membrane can have a color that is harmonized with the window decoration.

The aforementioned coloration conduction layer can be provided by mixing the conductive material and the non-conductive coloring material, and carbon fiber of a fiber form is used as the conductive material. At least any one of powder using metal of a powder form, conductive ink of a liquid sate, an electrically conductive organic material, such as PEDOT, ITO, IZO, CNT, and Al-doped Zinc Oxide (AZO) can be used. Ink for coloring can be used as the non-conductive coloring material. Meanwhile, the conductive material can be a liquid state, but can be provided in the form of powder and mixed and used with the non-conductive coloring material of a liquid sate.

Furthermore, transparent and conductive materials including at least any one of PEDOT, ITO, IZO, and AZO that are the conductive and organic materials can have a color due to a coloring material. The conductive materials of the aforementioned transparent material can be provided as the same color as powder or ink and can be mixed and used with the non-conductive coloring material of a liquid sate.

Furthermore, an oxide layer can be further interposed between the insulating substrate and the window decoration and can be provided along the window decoration region. The oxide layer can be provided as a metal oxide thin film, such as SiO₂, TiO₂, or Al₂O₃. After forming the oxide layer on the bottom of the insulating substrate, the electrode pattern can be formed and the coloration conduction layer and the window decoration can be formed. Order of the oxide layer and the electrode pattern that are formed can be changed acceding to circumstances. More particularly, the electrode pattern may be first formed on the bottom of the insulating substrate, and the oxide layer may be then formed at the window decoration part through sputtering and selective etching. The oxide layer may be provided in a single layer, and a plurality of the oxide layers may be formed, if necessary.

Furthermore, in accordance with yet another exemplary embodiment of the present invention, a touch panel sensor for sensing the contact position of a target object can include a transparent insulating substrate, a plurality of electrode patterns formed on the bottom of the transparent insulating substrate and configured to sense the access of the target object, and a penetration region provided along the circumference of the insulating substrate at the bottom of the insulating substrate and configured to have part of the ends of the plurality of electrode patterns exposed at the bottom of the insulating substrate. Here, the penetration region can include a window decoration provided in a specific symbol form and a colored layer provided in the penetration region and configured to visually distinguish the penetration region, provided in a symbol form, from the surrounding window decoration. Here, the "symbol" can generally refer to a mask, a letter, and a sign which are used to indicate any meaning, and the symbol can be used to refer to numbers, letters of various languages, and figures.

Here, the colored layer is provided as a single layer unlike the coloration conduction layer having the plurality of individual membranes. The colored layer is made of a conductive material including at least any one of silver paste, carbon fiber, carbon powder, powder using metal and an alloy, conductive ink, and conductive and organic material so that the color of the conductive material itself can be visually distinguished from that of the window decoration.

Furthermore, the conductive material can be visually distinguished from the window decoration more positively by way of a coloring material acceding to circumstances. Ink for coloring can be used as the coloring material. Here, the conductive material can be made of at least any one of silver paste, carbon fiber, carbon powder, and powder using metal or an alloy, and conductive ink which unique colors, and the coloring material can be used additionally. Furthermore, the transparent and conductive materials including at least any one of PEDOT, ITO, IZO, and AZO that are the conductive and organic materials can have a color due to the coloring material. The transparent and conductive materials can be provided in a powder or ink form and can be mixed and used with a non-conductive coloring material of a liquid sate.

As described above, the touch panel sensor in accordance with the present invention can improve a commodity value in design because the opaque elements of the touch panel sensor that can be visible to the outside through the penetration region, more particularly, a metallic connection pattern or a flexible circuit board are prevented from being visible to the outside through the colored layer and the opaque elements are also visually distinguished from the window decoration.

If the colored layer is non-conductive, a transparent and conductive layer can be additionally provided between the bottom of the transparent insulating substrate and the colored layer. The electrode pattern can be electrically connected to an external flexible circuit board or a main circuit by the transparent and conductive layer. Here, the transparent and conductive layer can be electrically connected to the external flexible circuit board or the main circuit by the metallic connection pattern provided on the bottom of the window decoration.

### [Advantageous Effects]

In the touch panel sensor of the present invention, the penetration region is formed at a part where the window decoration and the upper transparent electrode pattern formed on the bottom of the upper insulating substrate overlap with each other. Accordingly, a bend is not formed at the end of the upper transparent electrode pattern, and damage to the upper transparent electrode pattern due to the bending or the upper insulating substrate or an external shock can be minimized.

The touch panel sensor of the present invention can prevent the inside of the touch panel sensor from being visible through the penetration region because the coloration conduction layer is formed in the penetration region.

### [Description of Drawings]

FIG. 1 is a perspective view illustrating a conventional touch panel sensor of a capacitive method.
FIG. 2 is an exploded perspective view for illustrating a touch panel sensor in accordance with an embodiment of the present invention.
FIG. 3 is a rear perspective view of an upper sheet from the touch panel sensor in accordance with an embodiment of the present invention.
FIG. 4 is an enlarged cross-sectional view of a part taken in a direction A-A in order to describe the coupling structure of a conductive connection pattern and a coloration conduction layer in FIG. 3.
FIG. 5 is a reference diagram for illustrating a problem that can occur when a bend is generated in an upper transparent electrode pattern.
FIG. 6 is a rear perspective view of the upper sheet of a touch panel sensor in accordance with another embodiment of the present invention.
FIG. 7 is a rear perspective view of the upper sheet of a touch panel sensor in accordance with yet another embodiment of the present invention.
FIG. 8 is a partial exploded perspective view of a touch panel sensor in accordance with still yet another embodiment of the present invention.
FIG. 9 is a rear perspective view of the upper sheet of a touch panel sensor in accordance with still yet another embodiment of the present invention.
FIG. 10 is an enlarged cross-sectional view of the upper sheet of FIG. 9 taken in a direction A-A.
FIG. 11 is an enlarged cross-sectional view of the upper sheet of a touch panel sensor in accordance with yet another embodiment of the present invention.
FIG. 12 is a rear view of the upper sheet of a touch panel sensor having penetration regions having different forms in accordance with the present invention.
FIG. 13 is a partial exploded perspective view of a touch panel sensor in accordance with still yet another embodiment of the present invention.
FIG. 14 is a plan view of the upper sheet of the touch panel sensor of FIG. 13.
FIG. 15 is a plan view of a flexible circuit board electrically connected to the upper sheet of FIG. 13.
FIG. 16 is an enlarged cross-sectional view of a part of the flexible circuit board shown in FIG. 13 taken in a direction B-B.
FIG. 17 is a rear view of the insulating substrate of a touch panel sensor in accordance with yet another embodiment of the present invention.

### [Mode for Invention]

Hereinafter, the preferred embodiments of the present invention are described with reference to the accompanying drawings, but the present invention is not limited to the embodiments. For reference, in this description, the same reference numeral substantially denotes the same element, contents described in other figures can be cited and described under this rule, and contents that are determined to be evident to a person having ordinary skill in the art and that are repeated can be omitted.

The present invention relates to a touch panel sensor that is used in a display module and configured to sense the contact position of part of the body.

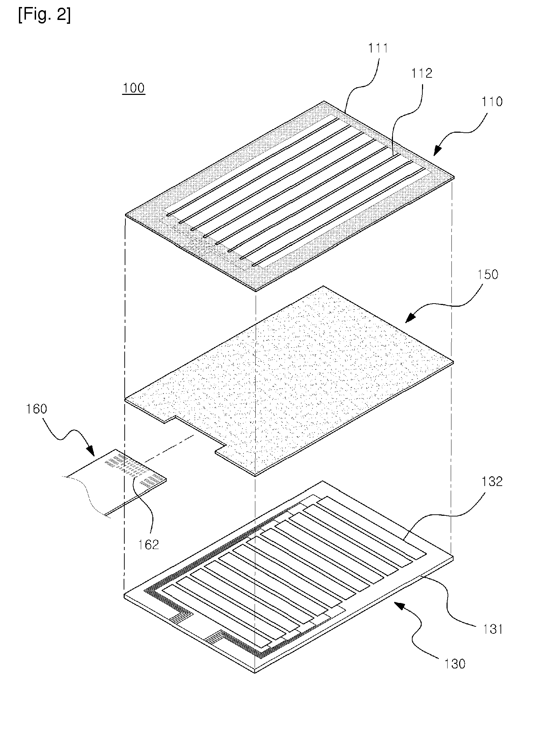

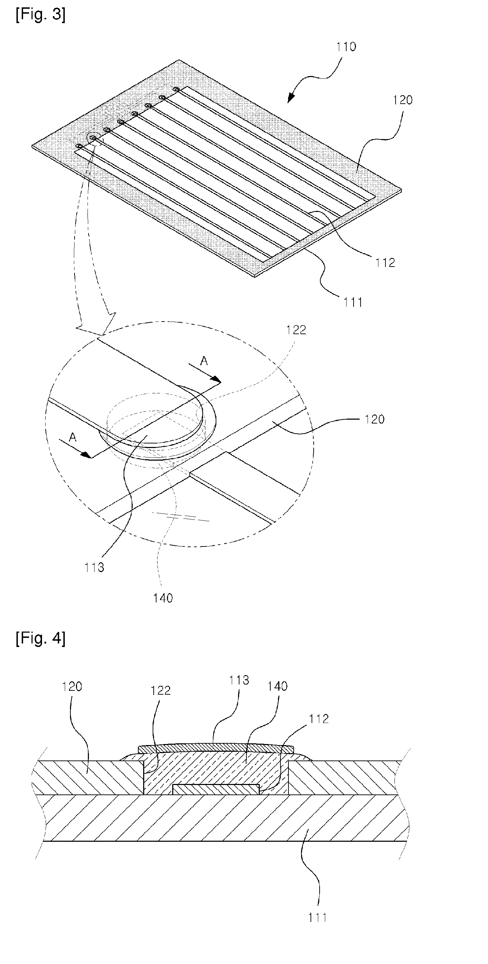

FIG. 2 is an exploded perspective view for illustrating a touch panel sensor in accordance with an embodiment of the present invention, FIG. 3 is a rear perspective view of an upper sheet from the touch panel sensor in accordance with an embodiment of the present invention, and FIG. 4 is an enlarged cross-sectional view of a part taken in a direction A-A in order to describe the coupling structure of a conductive connection pattern and a coloration conduction layer in FIG. 3.

Referring to FIGS. 2 to 4, the touch panel sensor 100 includes an upper sheet 110, a lower sheet 130, and an insulating member 150.

The upper sheet 110 includes an upper insulating substrate 111 and upper transparent electrode patterns 112, and the lower sheet 130 includes a lower insulating substrate 131 and lower transparent electrode patterns 132.

The upper insulating substrate 111 can be made of material having a high surface strength and can be fabricated using glass or plastic material that transmits light like glass or glass and has an excellent surface strength. Likewise, the lower insulating substrate 131 in which the lower transparent electrode patterns 132 that interact with the upper transparent electrode patterns 112 in the lower sheet 130 are disposed can be fabricated using the same material as the upper insulating substrate 111.

For reference, the upper and the lower insulating substrates can be made of synthetic resin, such as polyethylene, polypropylene, acryloyl, or polyethylene terephthalate (PET), or reinforced plastic, such as polycarbonate. In particular, the upper insulating substrate preferably is made of reinforced plastic or reinforced or tempered glass because it is directly exposed to the outside.

Meanwhile, the upper transparent electrode patterns 112 and the lower transparent electrode patterns 132 capable of sensing part of the body accessing thereto by way of an interaction are formed on the bottom surface of the upper insulating substrate 111 and on the top surface of the lower insulating substrate 131, respectively. The upper transparent electrode patterns 112 or the lower transparent electrode patterns 132 can be made of Indium Tin Oxide (ITO) or Indium Zinc Oxide (IZO) having both transparency and conductivity. Accordingly, the upper transparent electrode patterns 112 or the lower transparent electrode patterns 132 can be made of a transparent material capable of transmitting light that is emitted from a display module, such as a PDP or an LCD, which is not visible to the outside and can be disposed under the touch panel sensor 100.

Furthermore, the insulating member 150 is disposed between the upper sheet 110 and the lower sheet 130. The upper transparent electrode patterns 112 and the lower transparent electrode patterns 132 can be electrically separated from each other by the insulating member 150. The insulating member 150 is formed of an optical adhesive film or an Optically Clear Adhesive (OCA) film. The insulating member 150 joins the upper sheet 110 and the lower sheet 120, well transmits light, and has an excellent optical property.

As described above, the upper transparent electrode patterns 112 are not visible to the outside because it is made of ITO or IZO that is widely used as a transparent electrode, from among conductive and transparent materials. The upper transparent electrode patterns 112 may be provided using an opaque conductive material acceding to circumstances. For example, a variety of metals, such as gold, silver, and aluminum, or alloys can be used as the upper transparent electrode patterns 112. If the opaque conductive material is used as the material of the electrode patterns, the opaque conductive material must be thin enough so that an image of a display module is exposed without being blocked. More particularly, if the width of the electrode pattern made of the opaque material exceeds 0 to 30 *µ*m or less, the electrode pattern is rarely seen by the naked eye.

The upper transparent electrode patterns 112 provided as described above are not seen by an eye, but conductive connection patterns 113 electrically connected to the ends of the upper transparent electrode patterns 112 at the edge of one side of the upper insulating substrate 111 can be visible to the outside because they are made of non-transparent metal.

A window decoration 120 is disposed in the form of a frame along the circumference of the upper insulating substrate 111 at the bottom surface of the upper insulating substrate 111. The window decoration 120 prevents the conductive connection patterns 113 from being visible to the outside.

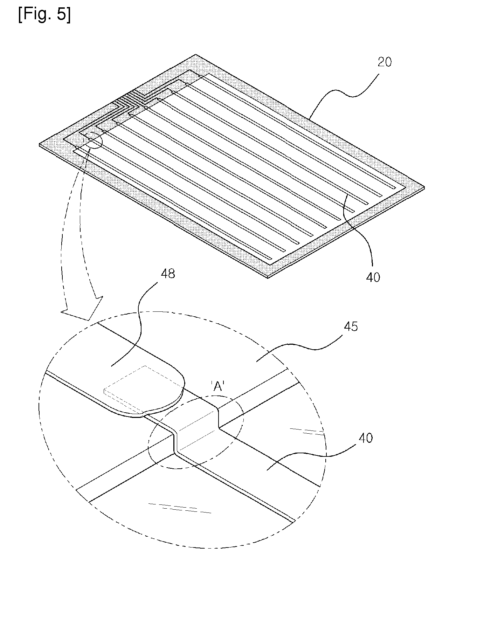

Meanwhile, in the present invention, penetration regions 122 in which the respective ends of the upper transparent electrode patterns 112 are disposed are formed in the window decoration 120 so that the ends of the upper transparent electrode patterns 112 are prevented from being bent and formed by the window decoration 120 at boundary portions where the window decoration 120 meets the upper transparent electrode patterns 112. Thus, a bend is not generated at the end of the upper transparent electrode pattern 112, and damage to the upper transparent electrode patterns 112 due to the bending of the upper insulating substrate 111 or an external shock can be minimized. For example, if a window decoration 45 is first formed on the bottom surface of an upper insulating sheet 20 and connection lines 48 are then formed on the bottom surface of the window decoration 45 as shown in FIG. 5, each of upper ITO electrodes 40 can be bent at a boundary portion A at which the window decoration 45 meets the upper ITO electrode 40. This bending structure of the upper ITO electrode 40 may easily damage the upper ITO electrode 40 when the upper insulating sheet 20 that is minutely bent up and down when part of the body touches the touch panel sensor is bent and deformed. Accordingly, this process of the touch panel sensor is not suitable for producing a product practically.

Furthermore, in the present embodiment, the penetration region is provided in the form of a hole through which the end of the upper transparent electrode pattern 112 in the penetration region 122 is exposed. The penetration region may be provided in the form of an incision pattern having a U form which extends from a boundary at which the window decoration meets the upper transparent electrode pattern to the end of the upper transparent electrode pattern acceding to circumstances.

Referring back to FIGS. 2 to 4, the conductive connection patterns 113 for electrically coupling the upper transparent electrode patterns 112 and an external circuit board 160 are formed on the bottom surface of the upper insulating substrate 111. In general, the width of the conductive connection pattern 113 may be about 300 *µ*m so that the conductive connection patterns 113 can be easily connected to the circuit board 160. In this case, the conductive connection patterns 113 can be seen by the naked eye through the penetration regions 122 outside the upper insulating substrate 111 that well transmits light, which may have a bad influence in terms of a beauty.

Coloration conduction layers 140 are disposed in the respective penetration regions 122 so that the conductive connection patterns 113 electrically connected to the ends of the upper transparent electrode patterns 112 are prevented from being exposed to the outside through the penetration regions 122.

The coloration conduction layers 140 can be made of material having conductivity and preferably is made of material that does not transmit light and has low reflection. For example, material including a conductive material, such as carbon, can be used as the coloration conduction layers 140, and the coloration conduction layers 140 can be formed by a coating, printing, silkscreen, ink-jet, deposition, pad printing, or masking method using a mixture of a hardening agent or an ultraviolet hardening agent and an adhesive.

By forming the conductive connection patterns 113 over the aforementioned coloration conduction layers 140, the ends of the upper transparent electrode patterns 112 and the conductive connection patterns 113 disposed in the penetration regions 122 can be electrically coupled and the coloration conduction layers 140 can prevent the opaque conductive connection patterns 113 from being exposed to the outside. For reference, the coloration conduction layers 140 can be provided so that they have a color similar to that of the window decoration 120 in order for them to be easily distinguished from the window decoration 120 on the outside. When the touch panel sensor 100 is practically used, the conductive connection patterns 113 are disposed under the coloration conduction layers 140, so the conductive connection patterns 113 are not seen because they are covered by the coloration conduction layers 140.

Meanwhile, the window decoration 120 commonly has a thickness of about 1 *µ*m or higher and commonly has a thickness thicker than the upper transparent electrode patterns 112 which is 1 *µ*m or less. Accordingly, the coloration conduction layers 140 can cover the penetration regions 122 and also fill the grooves of the penetration regions 122 which may occur due to a difference between the thickness of the window decoration 120 and the thickness of the upper transparent electrode patterns 112.

As described above, the upper transparent electrode patterns 112 are electrically connected to the external circuit board 160 through the conductive connection patterns 113 that are formed on the bottom surface of the coloration conduction layers 140 provided in the penetration regions 122.

For reference, as shown in the drawings, the conductive connection patterns 113 electrically connected to the upper transparent electrode patterns 112 and other conductive connection patterns electrically connected to the lower transparent electrode patterns 132 are brought in contact with the electrodes 162 of the circuit board 160 formed in different surfaces of the circuit board 160 and thus electrically connected to the electrodes 162. The insulating member 150 is provided in a partially incised part of a portion where the circuit board 160 is disposed.

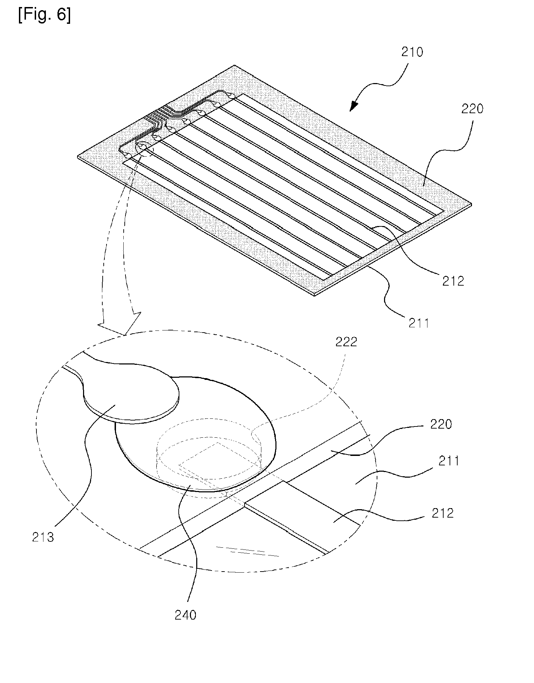

FIG. 6 is a rear perspective view of the upper sheet of a touch panel sensor in accordance with another embodiment of the present invention.

For descriptions of the upper sheet 210, the upper insulating substrate 211, the upper transparent electrode patterns 212, the conductive connection patterns 213, the window decoration 220, the penetration regions 222, and the coloration conduction layers 240 of the touch panel sensor shown in FIG. 6, reference can be made to the descriptions of the elements of the touch panel sensor described in connection with the above embodiment. In the present embodiment, a difference between the above embodiment and the present embodiment is chiefly described.

In the touch panel sensor 100 described with reference to FIGS. 2 to 4, each of the conductive connection patterns 113, that is, wire members, is connected to the coloration conduction layer 140 within the boundary of the penetration region 122. In contrast, each of the coloration conduction layers 240 shown in FIG. 6 is extended from the inside of the boundary of the penetration region 222, formed in the window decoration 220, to the outside of the boundary of the penetration region 222. Accordingly, the conductive connection pattern 213, that is, a wire member, can be connected to the coloration conduction layer 240 outside the boundary of the penetration region 222.

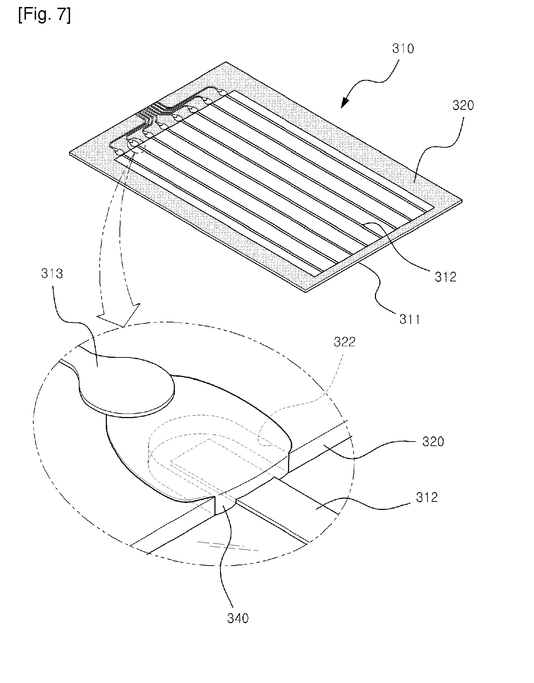

Furthermore, in the touch panel sensor 100 shown in FIGS. 2 to 4 and the touch panel sensor shown in FIG. 6, each of the penetration regions 122 and 222 is provided in the form of a closed ring-shaped hole through which the end of each of the upper transparent electrode patterns 112 and 212 is exposed. In yet another embodiment of the present invention, a penetration region 322 can be provided in the form of a U-shaped incision pattern that is extended from a boundary where a window decoration 320 and an upper transparent electrode pattern 312 meet together to the end of the upper transparent electrode pattern 312, as shown in FIG. 7. For reference, for descriptions of other elements of the touch panel sensor shown in FIG. 7, more particularly, an upper sheet 310, an upper insulating substrate 311, upper transparent electrode patterns 312, conductive connection patterns 313, and coloration conduction layers 340 shown in FIG. 7, reference can be made to the descriptions of the elements of the touch panel sensors shown in FIGS. 2 to 4.

Meanwhile, the coloration conduction layer can include non-conductive coloring ink and a conductive material. The coloration conduction layer can have higher resistance than metal in terms of the material. In general, resistance is proportional to the length and is in inverse proportion to an area. As shown in FIG. 4, the coloration conduction layer has a wider area than the upper transparent electrode pattern 112 disposed in the penetration region 122, and the thickness of the window decoration 120 is about 1 *µ*m and thus the thickness of the coloration conduction layer 140 disposed in the penetration region 122 is also very thin. Thus, the coloration conduction layer 140 can have a resistance value capable of transferring the electrical signal of the upper transparent electrode patterns 112 reasonably.

Any one of a conductive material of a fiber form, a conductive material of a powder form, and a conductive material of a liquid state can be used as the conductive material of the coloration conduction layer. Carbon fiber can be used as the conductive material of a fiber form, at least any one of carbon powder and metal powder can be used as the conductive material of a powder form, and at least any one of transparent PEDOT, ITO ink, IZO ink, and CNT ink can be used as the conductive material of a liquid state.

In particular, carbon fiber is very useful in reducing the resistance of the coloration conduction layer. For example, if the length of the coloration conduction layer 240 becomes long as shown in FIG. 6, carbon fiber is very effective in reducing the resistance of the coloration conduction layer 240 that increases in proportion to the length.

For reference, the meaning that the coloration conduction layer has a color in harmony with the window decoration can be used as a meaning that the coloration conduction layer has a color that is the same as or similar to the color of the window decoration so that the coloration conduction layer and the window decoration are not visually distinguished from each other. Acceding to circumstances, although the coloration conduction layer and the window decoration are visually distinguished from each other because the coloration conduction layer has a color distinguished from the color of the window decoration, if the coloration conduction layer has a pattern that is meaningful in the logo of a manufacturer, the brand name of a product, or a design, the meaning that the coloration conduction layer has a color in harmony with the window decoration may mean a case where a commodity value can be improved in terms of the design.

In the touch panel sensors according to the aforementioned embodiments, the upper transparent electrode patterns can be connected to the end of a flexible circuit board through the medium of the coloration conduction layers and the conductive connection patterns.

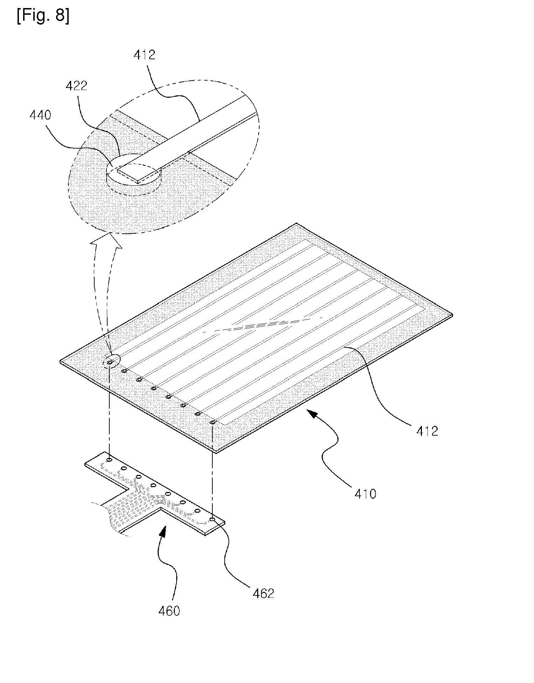

However, the coloration conduction layers may be directly electrically connected to an external main circuit using the flexible circuit board by way of wire members even without an additional conductive connection pattern. A touch panel sensor shown in FIG. 8 below is described as an example in detail.

FIG. 8 is a partial exploded perspective view of a touch panel sensor in accordance with still yet another embodiment of the present invention. Referring to FIG. 8, upper terminals 462 are disposed on the top surface of the flexible circuit board 460 and are directly connected to respective coloration conduction layers 440 disposed in respective penetration regions 422 through which upper transparent electrode patterns 412 are exposed. Here, each of the upper terminals 462 can be disposed within the boundary of the penetration region 422 and thus directly connected to the coloration conduction layer 440. Likewise, although not shown in FIG. 8, lower terminals connected to lower transparent electrode patterns can be disposed on the bottom surface of the flexible circuit board 460.

That is, the upper transparent electrode patterns 412 according to the present embodiment are electrically connected to the upper terminals 462 provided on the top surface of the flexible circuit board 460 even without an additional conductive connection pattern and are electrically connected to a main circuit through the flexible circuit board 460. For reference, the main circuit can be used as a concept which includes a central processing unit or a control device capable of receiving an electrical signal, such as a change in the capacitance of the electrode pattern, and sensing or calculating the contact position of a target object based on the received electrical signal.

Likewise, although not shown in FIG. 8, the lower transparent electrode patterns may be electrically connected to the lower terminals of the flexible circuit board 460 even without additional conductive connection pattern and electrically connected to the upper transparent electrode patterns 412 using additional conductive connection patterns.

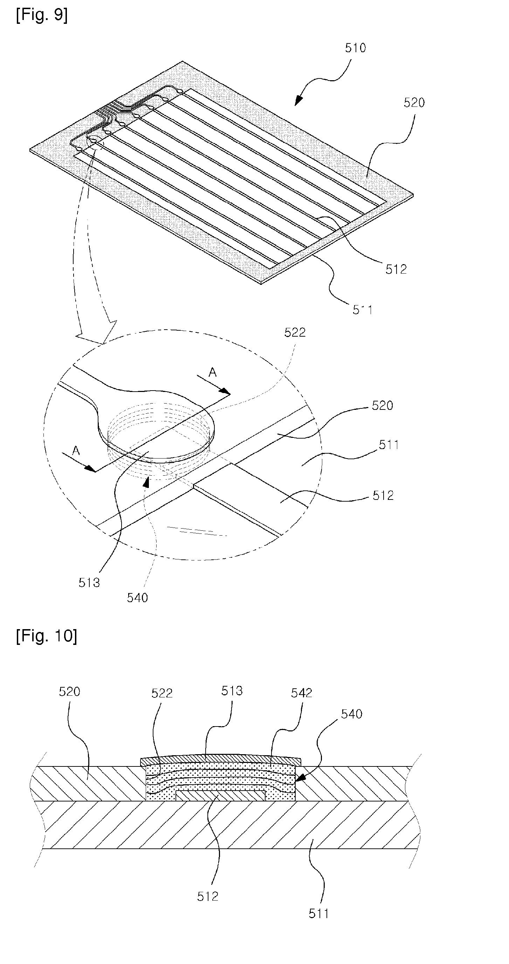

FIG. 9 is a rear perspective view of the upper sheet of a touch panel sensor in accordance with still yet another embodiment of the present invention, and FIG. 10 is an enlarged cross-sectional view of the upper sheet of FIG. 9 taken in a direction A-A.

Referring to FIGS. 9 and 10, the touch panel sensor 500 includes an upper sheet 510, a lower sheet, and an insulating member. For reference, the lower sheet and the insulating member of the present embodiment are substantially the same as those of the aforementioned embodiments. For descriptions and drawings of the lower sheet and the insulating member of the present embodiment, reference can be made to the descriptions and drawings of the lower sheet and the insulating member of the aforementioned embodiments.

The upper sheet 510 includes an upper insulating substrate 511 and upper transparent electrode patterns 512. In the present embodiment, ITO or IZO, that is, a transparent material, is used as the upper transparent electrode patterns 512 and lower transparent electrode patterns, but an opaque material, such as metal or an alloy, can be used as the upper transparent electrode patterns 512 and lower transparent electrode patterns acceding to circumstances. If the width of the electrode pattern made of the opaque material exceeds 0 to 30*µ*m or less, the electrode pattern is rarely seen by the naked eye. For reference, if the width of an opaque metallic electrode pattern is limited to the above value, the opaque metallic electrode pattern is visually rarely seen. A dark layer using dark metal, for example, any one of copper/titanium (Cu/Ti), molybdenum (Mo), chrome (Cr), and black Cr may be further provided on the metallic electrode pattern. Furthermore, a minute embossing or unevenness structure capable of refracting light can be provided on the top surface of the metallic electrode pattern or on the top surface of the dark layer so that diffused reflection is generated more effectively on a surface of the metallic electrode pattern, thereby lowering a mirroring effect.

As described above, the upper transparent electrode patterns 512 are transparent and thus not visible to the outside. Here, conductive connection patterns 513 made of silver paste are disposed at the edge of one side of the upper insulating substrate 511 and are electrically connected to the ends of the upper transparent electrode patterns 512. The conductive connection patterns 513 can be visible to the outside because they are made of non-transparent metal, and a flexible circuit board electrically connected to the conductive connection patterns 513 can also be visible to the outside.

Accordingly, in order to prevent the conductive connection patterns 513 and the flexible circuit board from being visible on the outside, a window decoration 520 is disposed in the form of a frame along the circumference of the upper insulating substrate 511 on the bottom surface of the upper insulating substrate 511.

In the present invention, penetration regions 522 in which the respective ends of upper transparent electrode patterns 512 are disposed are formed in the window decoration 520 so that the end of each of the upper transparent electrode patterns 512 is not bent at a boundary portion where the window decoration 520 and the upper transparent electrode pattern 512 meet together. Accordingly, a bend does not occur at the end of the upper transparent electrode pattern 512, and thus damage to the upper transparent electrode patterns 512 due to the bending of the upper insulating substrate 511 or an external shock can be minimized.

Here, the conductive connection patterns 513 may be exposed to the outside due to the aforementioned penetration regions 522. In the present invention, however, coloration conduction layers 540 disposed in the penetration regions 522 can prevent the bottom surface of the touch panel sensor 500 from being visible through the penetration regions 522. The coloration conduction layers 540 are described in detail later.

In the present embodiment, the penetration region 522 is provided in the form of a closed ring-shaped hole through which the end of the upper transparent electrode pattern 512 is exposed. In another embodiment of the present invention, the penetration region may be provided in the form of a U-shaped incision pattern that is extended from a boundary portion where the window decoration and the upper transparent electrode pattern meet together to the end of the upper transparent electrode pattern.

Referring back to FIGS. 9 and 10, each of the conductive connection patterns 513 for electrically coupling the upper transparent electrode patterns 512 and the flexible circuit board 560 on the bottom surface of the window decoration 520 is connected to each of the coloration conduction layers 540 within the boundary of the penetration region 522.

The conductive connection pattern 513 can be seen by the naked eye through the penetration region 522 outside the upper insulating substrate 511, but the coloration conduction layer 540 can prevent this exposure.

Referring back to FIGS. 9 and 10, the coloration conduction layers 540 can prevent the inside of the touch panel sensor 500 from being exposed through the penetration regions 522 by blocking light in the penetration regions 522 and can electrically couple the upper transparent electrode patterns 512 and an external main circuit through the medium of the conductive connection patterns 513 and the flexible circuit board 560.

The coloration conduction layer 540 can include non-conductive coloring ink as a conductive material and a coloring material. The coloration conduction layer 540 can have higher resistance than metal in terms of the material. In general, resistance is proportional to the length and is in inverse proportion to an area. The coloration conduction layer 540 has a larger area than the upper transparent electrode pattern 512 disposed in the penetration region 522, as shown in FIG. 10. Furthermore, the thickness of the window decoration 520 is commonly about 1 *µ*m, and thus the thickness of the coloration conduction layer 540 disposed in the penetration region 522 is also very thin. Accordingly, the coloration conduction layer 540 can have a resistance value capable of transferring the electrical signal of the upper transparent electrode pattern 512 reasonably.

At least any one of carbon fiber, carbon powder, powder using metal, conductive ink, PEDOT, ITO, IZO, AZO, and CNT can be used as the conductive material of the coloration conduction layer. In particular, the conductive material can be transparent when it includes at least any one of PEDOT, ITO, IZO, and AZO. This conductive material can be provided in a liquid state or in the form of powder and can be mixed and used with a non-conductive coloring material.

Meanwhile, at least any one of PEDOT, ITO ink, IZO ink, and CNT ink can be used as the transparent and conductive ink. The conductive transparent ink can be fabricated by dispersing PEDOT, ITO, IZO, AZO, or CNT of a powder state in a proper solvent.

The aforementioned coloration conduction layers 540 can be formed by a variety of methods, such as a printing, silkscreen, ink-jet, pad printing, masking, or deposition method by mixing a conductive material, a coloring material, and an adhesive, such as a thermosetting agent or an ultraviolet hardening agent.

For reference, the pad printing may mean a method of imprinting a printing body on a surface of a target printing body that may include glass having a smooth surface, such as glass, tempered glass, or porcelain, using a pad having elasticity, raising the printing body, and then transferring the ink to the target printing body. In particular, the coloration conduction layer having a thickness of about 1 *µ*m as compared with the thickness of the window decoration is provided using the pad printing method because the thickness of each layer is smaller than the thickness of about 1 *µ*m. Accordingly, the coloration conduction layer can be printed with high quality.

The coloration conduction layer 540 includes a plurality of individual stacked membranes 542 as shown in FIG. 10 (in the present embodiment, the coloration conduction layer includes four individual membranes, but the number of individual membranes can be changed into 2 or more as one likes). Each of the individual membranes 542 has a different mixing ratio of the conductive material and the non-conductive coloring material. In accordance with the present embodiment, the ratio of the non-conductive coloring material to the conductive material included in the individual membrane 542 is gradually increased toward the top surface of the upper insulating substrate 511.

The non-conductive coloring material, as described above, is provided so that the window decoration 520 is harmonized with the coloration conduction layers 540. As the ratio of the non-conductive coloring material increases, the individual membranes 542 can have a color that is in harmony with the window decoration 520.

Accordingly, the individual membranes 542 having a relatively higher ratio of the non-conductive coloring material are disposed close to the top surface of the upper insulating substrate 511. Thus, control can be easily performed so that the color of the coloration conduction layers 540 is in harmony with the color of the window decoration 520 through the individual membranes 542.

The ratios of the conductive materials and the non-conductive coloring materials of the individual membranes are set as in [Table 1] below. In [Table 2] to [Table 9], a change of a resistance value according to the length of each layer is listed. Carbon can be used as the conductive material for the individual membrane, and non-conductive coloring ink can be used as the non-conductive coloring material for the individual membrane.

In the present embodiment, the coloration conduction layer is formed using four individual membranes selected from the individual membranes of [Table 2] to [Table 9], and an individual membrane having a higher ratio of the conductive material to the coloring material can be disposed close to the conductive connection pattern.

**[Table 1] The ratio of the conductive material and the non-conductive coloring material for each individual membrane**

| | CONDUCTIVE MATERIAL:COLORING MATERIAL |
|---|---|
| First individual membrane | 90:10 |
| Second individual membrane | 80:20 |
| Third individual membrane | 70:30 |
| Fourth individual membrane | 60:40 |
| Fifth individual membrane | 50:50 |
| Sixth individual membrane | 40:60 |
| Seventh individual membrane | 30:70 |
| Eighth individual membrane | 20:80 |

Furthermore, a resistance value can be higher than other individual membranes because the ratio of the non-conductive coloring material is greater than the ratio of the conductive material from the first individual membrane toward the eighth individual membrane. In the present invention, however, there is a tendency that a resistance value from the upper transparent electrode pattern 512 to the conductive connection pattern 513 via the coloration conduction layers 540 does not greatly depend on the coloration conduction layers 540 practically because the coloration conduction layer is formed of the plurality of individual stacked membranes.

Furthermore, as described above, the coloration conduction layer has a higher resistance than metal in terms of the material, but the coloration conduction layer has a larger area than the upper transparent electrode pattern disposed in the penetration region as shown in FIG. 10, and the thickness of the window decoration is about 1 *µ*m and thus the thickness of the coloration conduction layer disposed in the penetration region is also very thin. Although the ratio of the conductive material and the non-conductive coloring material in the individual membrane is changed, it can be seen that the resistance value of the individual membrane is changed within a range in which the electrical signal of the upper transparent electrode pattern can be transferred to the main circuit.

For reference, as the length of the individual membrane is increased, the resistance value of the individual membrane is increased. For this, reference can be made to [Table 2] to [Table 9] below.

**[Table 2] Measurement of resistance values depending on the lengths of the first individual membrane**

| CONDUCTIVE MATERIAL: COLORING MATERIAL (%) | 90:10 | | | | | | | | | | | |
|---|---|---|---|---|---|---|---|---|---|---|---|---|
| LENGTH (MM) | 10 | | | 20 | | | 30 | | | 40 | | |
| SAMPLE | 1 | 2 | 3 | 1 | 2 | 3 | 1 | 2 | 3 | 1 | 2 | 3 |
| RESISTANCE VALUE (KΩ) | 1.4 | 1.5 | 2.1 | 5.6 | 5.7 | 6.2 | 8.7 | 8.7 | 9.0 | 11.8 | 12.0 | 12.6 |
| AVERAGE | 1.6 | | | 5.8 | | | 8.8 | | | 12.1 | | |

**[Table 3] Measurement of resistance values depending on the lengths of the second individual membrane**

| CONDUCTIVE MATERIAL: COLORING MATERIAL (%) | 80:20 | | | | | | | | | | | |
|---|---|---|---|---|---|---|---|---|---|---|---|---|
| LENGTH (MM) | 10 | | | 20 | | | 30 | | | 40 | | |
| SAMPLE | 1 | 2 | 3 | 1 | 2 | 3 | 1 | 2 | 3 | 1 | 2 | 3 |
| RESISTANCE VALUE (KΩ) | 2.4 | 2.3 | 2.6 | 7.3 | 7.4 | 7.2 | 11.1 | 11.0 | 11.0 | 15.0 | 14.7 | 14.9 |
| AVERAGE | 2.4 | | | 7.3 | | | 11.0 | | | 14.8 | | |

**[Table 4] Measurement of resistance values depending on the lengths of the third individual membrane**

| CONDUCTIVE MATERIAL: COLORING MATERIAL (%) | 70:30 | | | | | | | | | | | |
|---|---|---|---|---|---|---|---|---|---|---|---|---|
| LENGTH (MM) | 10 | | | 20 | | | 30 | | | 40 | | |
| SAMPLE | 1 | 2 | 3 | 1 | 2 | 3 | 1 | 2 | 3 | 1 | 2 | 3 |
| RESISTANCE VALUE (KΩ) | 5.6 | 5.5 | 5.8 | 12.8 | 12.8 | 13.1 | 18.8 | 19.2 | 19.6 | 27.8 | 26.7 | 26.3 |
| AVERAGE | 5.6 | | | 12.9 | | | 19.2 | | | 26.9 | | |

**[Table 5] Measurement of resistance values depending on the lengths of the fourth individual membrane**

| CONDUCTIVE MATERIAL: COLORING MATERIAL (%) | 60:40 | | | | | | | | | | | |
|---|---|---|---|---|---|---|---|---|---|---|---|---|
| LENGTH (MM) | | 10 | | | 20 | | | 30 | | | 40 | |
| SAMPLE | 1 | 2 | 3 | 1 | 2 | 3 | 1 | 2 | 3 | 1 | 2 | 3 |
| RESISTANCE VALUE (KΩ) | 6.5 | 8.0 | 9.2 | 22.7 | 23. 6 | 23. 6 | 35. 5 | 36. 4 | 37. 4 | 48.5 | 49. 8 | 49.4 |
| AVERAGE | | 7.9 | | | 23.3 | | | 36.4 | | | 49.2 | |

**[Table 6] Measurement of resistance values depending on the lengths of the fifth individual membrane**

| CONDUCTIVE MATERIAL: COLORING MATERIAL (%) | 50:50 | | | | | | | | | | | |
|---|---|---|---|---|---|---|---|---|---|---|---|---|
| LENGTH (MM) | 10 | | | 20 | | | 30 | | | 40 | | |
| SAMPLE | 1 | 2 | 3 | 1 | 2 | 3 | 1 | 2 | 3 | 1 | 2 | 3 |
| RESISTANCE VALUE (KΩ) | 1.6 | 13.6 | 13.6 | 33.0 | 31.1 | 31.5 | 48.4 | 47.2 | 46.4 | 69.8 | 64.5 | 63.9 |
| AVERAGE | 13.9 | | | 31.8 | | | 47.3 | | | 66 | | |

**[Table 7] Measurement of resistance values depending on the lengths of the sixth individual membrane**

| CONDUCTIVE MATERIAL: COLORING MATERIAL (%) | 40:60 | | | | | | | | | | | |
|---|---|---|---|---|---|---|---|---|---|---|---|---|
| LENGTH (MM) | 10 | | | 20 | | | 30 | | | 40 | | |
| SAMPLE | 1 | 2 | 3 | 1 | 2 | 3 | 1 | 2 | 3 | 1 | 2 | 3 |
| RESISTANCE VALUE (KΩ) | 40.7 | 40.0 | 36.7 | 87.5 | 89.3 | 86.3 | 131.3 | 133.1 | 132.8 | 174.8 | 175.2 | 171.7 |
| AVERAGE | 49.1 | | | 87.7 | | | 132.4 | | | 173.9 | | |

**[Table 8] Measurement of resistance values depending on the lengths of the seventh individual membrane**

| CONDUCTIVE MATERIAL: COLORING MATERIAL (%) | 30:70 | | | | | | | | | | | |
|---|---|---|---|---|---|---|---|---|---|---|---|---|
| LENGTH (MM) | 10 | | | 20 | | | 30 | | | 40 | | |
| SAMPLE | 1 | 2 | 3 | 1 | 2 | 3 | 1 | 2 | 3 | 1 | 2 | 3 |
| RESISTANCE VALUE | 144.2 | 129.0 | 111.4 | 324.4 | 286.3 | 259.2 | 423.2 | 413.2 | 403.1 | 0.6 | 0.5 | 0.5 |
| AVERAGE | 128.2 (KΩ) | | | 289.9 (KΩ) | | | 413.1 (KΩ) | | | 0.5 (KΩ) | | |

**[Table 9] Measurement of resistance values depending on the lengths of the eighth individual membrane**

| CONDUCTIVE MATERIAL: COLORING MATERIAL (%) | 20:80 | | | | | | | | | | | |
|---|---|---|---|---|---|---|---|---|---|---|---|---|
| LENGTH (MM) | 10 | | | 20 | | | 30 | | | 40 | | |
| SAMPLE | 1 | 2 | 3 | 1 | 2 | 3 | 1 | 2 | 3 | 1 | 2 | 3 |
| RESISTANCE VALUE (KΩ) | 5.7 | 5.0 | 4.6 | 10.2 | 10.1 | 9.7 | 16. 6 | 15. 9 | 14. 8 | 23. 2 | 21. 5 | 20. 7 |
| AVERAGE | 5.1 | | | 10 | | | 15.7 | | | 21.8 | | |

From [Table 2] to [Table 9], it can be seen that the coloration conduction layers having different mixing ratios of the conductive material and the non-conductive coloring material have a smaller difference between resistance values depending on the length as the length is reduced. It can be understood that when the coloration conduction layer is shorter and thinner, the resistance value of the coloration conduction layer belongs to a range that can transfer the electrical signal of the upper transparent electrode pattern to the main circuit reasonably. Furthermore, the diameter of the penetration region is practically 5 mm or less, and a resistance value according to the length can be negligible.

Furthermore, in the resistance value measurement experiments, the experiments were performed on cases where the ratio of the non-conductive coloring material to the conductive material is up to 20:80 as examples. An individual membrane having a higher ratio of the non-conductive coloring material can also be applied to the coloration conduction layer acceding to circumstances. A correction for a resistance value increased due to the high ratio of the non-conductive coloring material can be performed through another individual membrane having a higher ratio of the conductive material.

Meanwhile, the meaning that the coloration conduction layer has a color in harmony with the color of the window decoration can mean that the coloration conduction layer and the window decoration are not visually distinguished from each other when being seen on the outside because they have the same or similar colors and may include that the coloration conduction layer and the window decoration can be formed to have a similar or unified sense of beauty through a proper color match although they are distinguished from each other, if necessary.

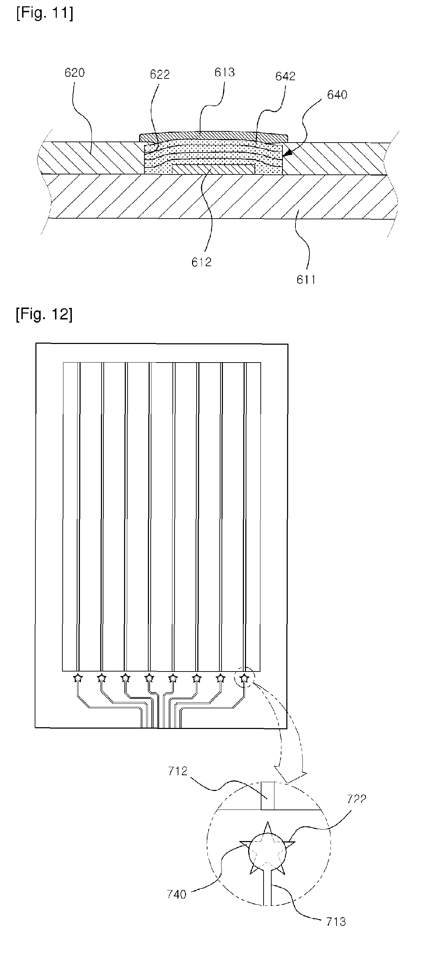

For example, as shown in FIG. 12, the shape of a penetration region 722 can be provided so that it corresponds to a polygon or a specific letter or figure, and the terminal of an upper transparent electrode pattern 712 can be disposed in the penetration region 722. Furthermore, acceding to circumstances, the penetration regions having different forms may be arranged, and the terminals of the upper transparent electrode patterns may be disposed in the respective penetration regions. A visually special meaning may be assigned to the coloration conduction layer 740 disposed in the penetration region 722, or a commodity value can be improved in terms of the design. For reference, conductive connection patterns 713 are provided under coloration conduction layers 740.

As described above with reference to FIGS. 9 and 10, the upper transparent electrode patterns 512 can be electrically connected to the conductive connection patterns 513, formed on the bottom surface of the window decoration 520, through the medium of the coloration conduction layers 540 provided in the penetration regions 522, and the conductive connection patterns 513 can be electrically connected to the terminals of a flexible circuit board. For reference, the conductive connection patterns 513 electrically connected to the upper transparent electrode patterns 512 and other conductive connection patterns electrically connected to lower transparent electrode patterns can be brought in contact with the electrodes of the flexible circuit board formed in different surfaces of the flexible circuit board and electrically connected to the electrodes of the flexible circuit board.

For reference, the coloration conduction layers 540 shown in FIG. 10 can be provided by providing the upper transparent electrode patterns 512 and the window decoration 520 on the upper insulating substrate 511 and then stacking the individual membranes 542 over the penetration regions 522.

In some embodiments, only the upper transparent electrode patterns 512 may be first provided on the upper insulating substrate 511, and the coloration conduction layers and the window decoration may be sequentially provided. This can be checked from the structure of an upper sheet, such as that shown in FIG. 11. More particularly, upper transparent electrode patterns 612 may be provided on an upper insulating substrate 611, and a window decoration 620 may be provided so that the penetration regions 622 of the window decoration 620 can be disposed at respective portions where the upper transparent electrode patterns 612 and coloration conduction layers 640 are formed. For reference, for a description of the conductive connection patterns 613 of a touch panel sensor shown in FIG. 11, reference can be made to the aforementioned embodiments.

Needless to say, the coloration conduction layers 640 can be patterned so that they correspond to the penetration regions 622 before the window decoration 620 is provided. In this case, since the coloration conduction layers 640 are formed prior to the window decoration 620, individual membranes 642 can be provided in a closed state without an empty space in the penetration region 622. Furthermore, if necessary, there is a method of providing the coloration conduction layers by providing the window decoration while providing the coloration conduction layers and then providing the remaining individual membranes.

For reference, in another embodiment, the upper transparent electrode patterns may be provided and then oxidized. The oxidized upper transparent electrode patterns have a specific color, thereby being capable of improving a commodity value. The oxidized upper transparent electrode patterns can be provided by generally forming a transparent electrode layer for the upper transparent electrode patterns on the bottom surface of an upper insulating substrate, oxidizing a surface of the transparent electrode layer, and patterning the transparent electrode layer.

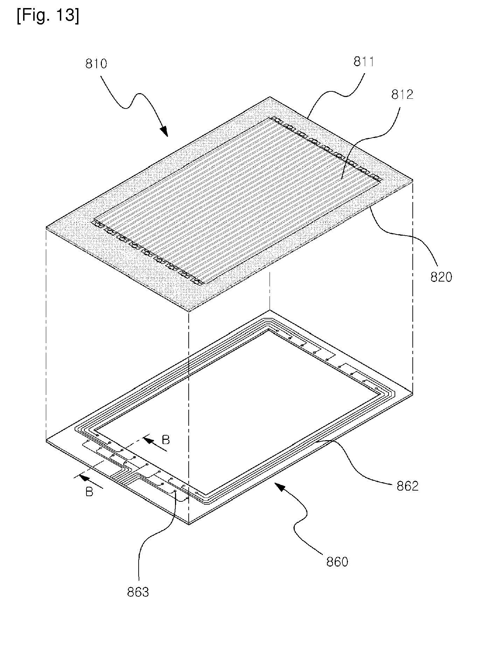

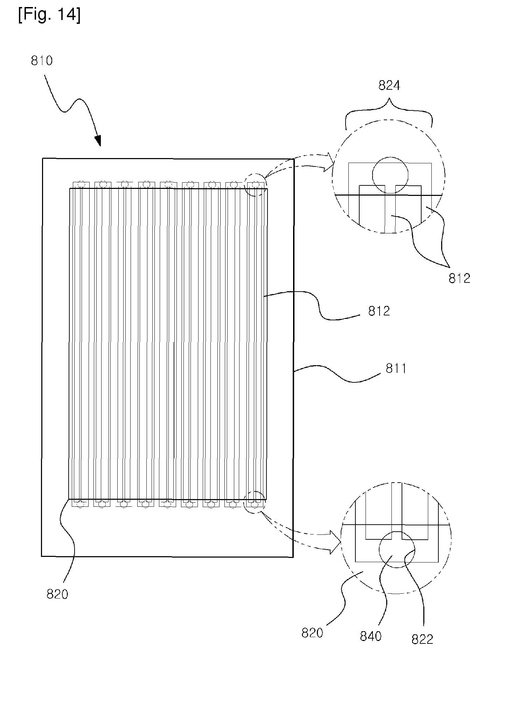

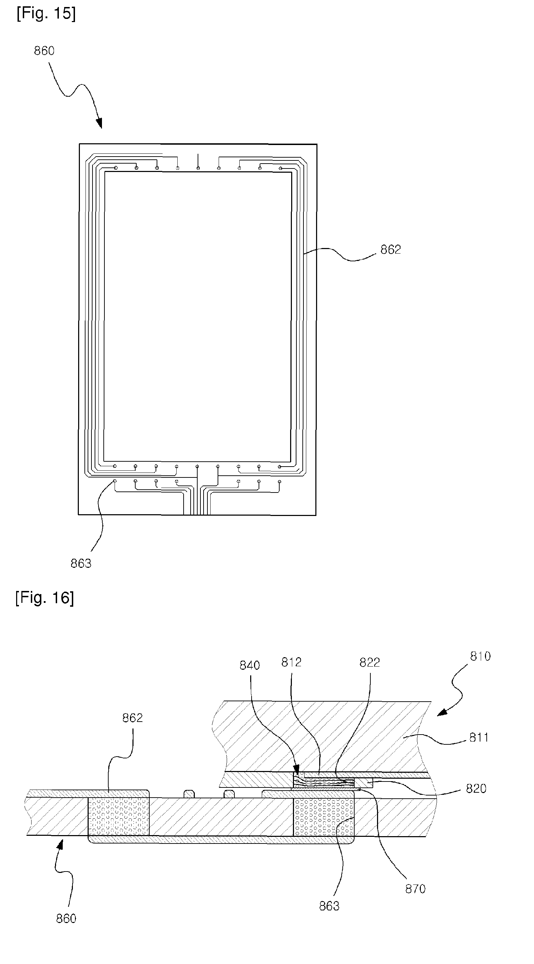

FIG. 13 is a partial exploded perspective view of a touch panel sensor in accordance with still yet another embodiment of the present invention, FIG. 14 is a plan view of the upper sheet of the touch panel sensor of FIG. 13, FIG. 15 is a plan view of a flexible circuit board electrically connected to the upper sheet of FIG. 13, and FIG. 16 is an enlarged cross-sectional view of a part of the flexible circuit board shown in FIG. 13 taken in a direction B-B.

The touch panel sensor shown in FIGS. 13 to 16 is substantially the same as the touch panel sensor according to the aforementioned embodiments. For a description of the touch panel sensor according to the present embodiments, reference can be made to the aforementioned embodiments. In the present embodiment, a difference between the touch panel sensor of the present embodiment and the touch panel sensor of the aforementioned present embodiment is chiefly described.

Referring to FIGS. 13 to 16, the upper sheet 810 of the touch panel sensor includes an upper insulating substrate 811 and a plurality of upper transparent electrode patterns 812 disposed at regular intervals.

In the present embodiment, a plurality of, for example, three upper transparent electrode patterns 812 has upper and lower ends coupled, thereby forming one electrode group 824. According to circumstances, one of the upper and lower ends of the upper transparent electrode patterns 812 or at least one point in the middle part of the upper transparent electrode patterns 812 may be electrically connected. The upper transparent electrode patterns 812 adjacent to each other are grouped, so a change of activated capacitance can be generated.

Each of the electrode groups 824 is partially exposed through the penetration region 822 of a window decoration 820, and the coloration conduction layer 840 is disposed in each of the penetration regions 822.

A flexible circuit board 860 is provided on the bottom surface of the upper insulating substrate 811 along the window decorations 820, and the flexible circuit board 860 forms a circuit that electrically couples the upper and lower ends of the upper transparent electrode patterns 812.

More particularly, the flexible circuit board 860 is provided in the form of a frame that is electrically connected to the electrode groups 824 at the upper and lower ends of the electrode groups 824. A plurality of connection terminals 862 for electrically coupling the upper and lower ends of the electrode groups 824 is disposed in the flexible circuit board 860. In the present embodiment, the connection terminals 862 couple the upper and lower ends of the electrode groups, but may couple the upper and lower ends of the electrode groups when the upper transparent electrode patterns are not grouped.

Meanwhile, via holes 863 are formed in the flexible circuit board 860 and are disposed close to respective points where the connection terminals 862 made of metal intersect each other. The connection terminals 862 can be prevented from coming in contact with each other through the via holes 863. More particularly, as shown in FIG. 16, the connection terminal 862 is guided from a point where the connection terminal 862 intersects another connection terminal 862 to the other surface of the circuit board 860 through the via hole 863, thereby preventing the connection terminals from coming in contact with each other. The via holes 863 may be integrally formed with the connection terminals using the same material as the connection terminals, but may be made of material capable of electrically coupling connection terminals provided in different surfaces of the circuit board.

For reference, referring to FIG. 16, there is shown the upper sheet 810. In this case, a portion where the upper sheet 810 and the flexible circuit board 860 are jointed is shown. As shown in FIG. 16, the coloration conduction layer 840 is disposed in the penetration region 822 of the window decoration 820 disposed on the bottom surface of the upper insulating substrate 811 of the upper sheet 810. Here, the coloration conduction layers 840 are jointed with the connection terminals 862 of the flexible circuit board 860 through the medium of an Anisotropic Conductive Film (ACF) film 870 and electrically connected to the connection terminals 862.

Here, the ACF film 870 is formed by dispersing conductive minute particles into an adhesive and is an adhesive material having electrical anisotropy of conductivity in the thickness direction of the film and an insulating property in the surface direction of the film through a thermal compression process.

Each of the touch panel sensors according to the aforementioned embodiments includes the two sheets of upper and lower insulating substrates having the upper and lower transparent electrode patterns formed on bottom and top surfaces of the upper and lower insulating substrates, respectively. If necessary, the touch panel sensor may include one sheet of an insulating substrate having the transparent electrode patterns formed on one of the top and bottom surfaces of the insulating substrate. This structure is described in detail below.

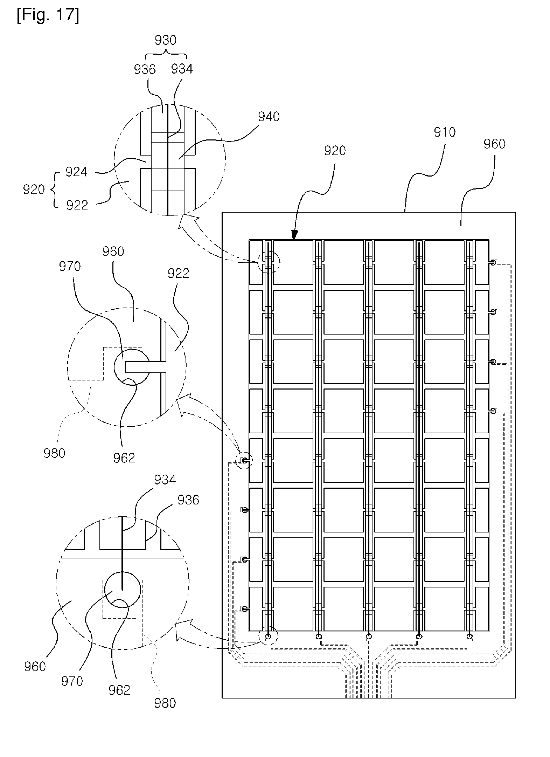

FIG. 17 is a rear view of the insulating substrate of a touch panel sensor in accordance with yet another embodiment of the present invention.

Referring to FIG. 17, the touch panel sensor according to the present embodiment includes an insulating substrate 910, first transparent electrode patterns 920 and second transparent electrode patterns 930 formed on the insulating substrate 910, and insulating patterns 940 interposed between the first transparent electrode patterns 920 and the second transparent electrode patterns 930.

The insulating substrate 910 can be formed of a synthetic resin film, such as transparent PET, PC, or PE, or a glass substrate.

The first transparent electrode patterns 920 and the second transparent electrode patterns 930 may be formed on one of the top and bottom surfaces of the insulating substrate 910.

The first transparent electrode patterns 920 can be made of a transparent and conductive material and are provided by a series of line patterns that are arranged in parallel in a horizontal or vertical direction on the insulating substrate 910. More particularly, each of the line patterns for the first transparent electrode patterns 920 includes an extension unit 922 and a bridge unit 924 provided in a row in one direction. The extension units 922 and the bridge units 924 are alternately formed and disposed in a row and may be made of the same or different transparent and conductive materials.

The extension unit 922 has a width relatively or significantly wider than that of the bridge unit 924. The bridge unit 924 is formed between the extension units 922, and the bridge unit 924 can electrically couple a series of the extension units 922.

The shapes of the extension unit 922 and the bridge unit 924 can have a consecutive square as a motive as shown, but can have a variety of figures, such as a lozenge, a circle, and an ellipse, as motives. Furthermore, the extension units 922 and the bridge units 924 can be made of the same material as transparent connection units 936 for the second transparent electrode patterns 930 and can be formed on the same surface as the transparent connection units 936. The shapes of the extension unit 922 and the bridge unit 924 can be selected so that the extension unit 922 and the bridge unit 924 are spaced apart from each other to a minimum width and the shapes of the extension unit 922 and the bridge unit 924 are harmonized with each other.

The second transparent electrode patterns 930 are formed so that they form a stack structure along with the first transparent electrode patterns 920. The second transparent electrode patterns 930 can be formed over or under the first transparent electrode patterns 920 and are formed so that they are electrically separated from the first transparent electrode patterns 920. To this end, the insulating patterns 940 can be formed between the first transparent electrode patterns 920 and the second transparent electrode patterns 930. In general, the insulating pattern 940 can be made of material, such as SiO₂, Si₃N₄, or TiO₂ which forms an insulating thin film.

Each of the second transparent electrode patterns 930 includes a low resistance line 934 and the transparent connection unit 936. The transparent connection units 936 can be formed simultaneously with the first electrode patterns 920, for example. Each of the transparent connection units 936 can be made of a transparent and conductive material having a width of about 0.1 to 0.2 mm. The transparent connection units 936 can be formed along with the extension units 922 and the bridge units 924 after etching an ITO layer formed in the insulating substrate 910 using a photolithography process.

As shown in FIG. 17, the low resistance lines 934 are formed on the insulating patterns 940 and formed to electrically couple all the transparent connection units 936 while passing through a surface of the plurality of transparent connection units 936. The low resistance lines 934 can be made of metal, such as gold, silver, aluminum, or chrome. The low resistance lines 934 can be formed by a patternization process after deposition or sputtering or may be simply formed by a process, such as ink-jet printing. The low resistance line 934 can block a display optically because it is not transparent. If the width of the low resistance line 934 is about 30 *µ*m or less, however, the low resistance line 934 is not seen by the naked eye. More preferably, if the width of the low resistance line 934 is about 10 *µ*m or less, the low resistance line 934 is not seen by the naked eye in any case.

Meanwhile, the edges of the first transparent electrode patterns 920 and the second transparent electrode patterns 930 are partially exposed through the penetration regions 962 of the window decoration 960. More particularly, the extension units 922 of the first transparent electrode patterns 920 are extended up to the penetration regions 962 and exposed, and the second transparent electrode patterns 930 are also extended up to the penetration regions 962 and exposed.

Coloration conduction layers 970 are disposed in respective penetration regions 962. The first transparent electrode patterns 920 and the second transparent electrode patterns 930 are electrically connected to conductive connection patterns 980 through the medium of the respective coloration conduction layers 970.

As described above, while the present invention has been described with reference to the preferred embodiments, a person having ordinary skill in the art will understand that the present invention can be modified and changed in various manners within the spirit and scope of the present invention written in the following claims.

### [Industrial Applicability]

The touch panel sensors according to the present invention can be widely applied to displays for sensing the contact position of a target object.

## Claims

1. A touch panel sensor for sensing a contact position of a target object, comprising:
an insulating substrate;
electrode patterns formed on a bottom surface of the insulating substrate and for sensing the target object accessing thereto;
a window decoration provided on the bottom surface of the insulating substrate in order to block light and including penetration regions through which respective ends of the electrode patterns are exposed;
coloration conduction layers provided in the respective penetration regions in order to block light and electrically connected to the electrode patterns; and
wire members electrically connected to the ends of the electrode patterns disposed in the penetration regions through a medium of the coloration conduction layers.

2. The touch panel sensor according to claim 1, wherein the insulating substrate comprises any one of glass, tempered glass, and synthetic resin.

3. The touch panel sensor according to claim 1, wherein the window decoration and the coloration conduction layers have harmonizing colors.

4. The touch panel sensor according to claim 1, wherein the coloration conduction layer is formed using coating, printing, silkscreen, ink-jet, deposition, pad printing, or masking.

5. The touch panel sensor according to claim 1, wherein the coloration conduction layer comprises a conductive material and non-conductive coloring ink having a color corresponding to the window decoration.

6. The touch panel sensor according to claim 5, wherein the conductive material is provided in a form of at least any state of powder, fibroid material, and a liquid state.

7. The touch panel sensor according to claim 6, wherein the conductive material comprises at least any one of carbon fiber, carbon powder, powder using metal, conductive ink, a conductive and organic material, polyethylenedioxythiophene (PEDOT), ITO, IZO, Al-doped zinc oxide (AZO), and carbon nanotube (CNT).

8. The touch panel sensor according to claim 1, wherein the electrode patterns are provided using a transparent or opaque conductive material.

9. The touch panel sensor according to claim 1, wherein each of the wire members is connected to the coloration conduction layer within a boundary of the penetration region.

10. The touch panel sensor according to claim 1, wherein the wire member is connected to the coloration conduction layer outside a boundary of the penetration region.

11. The touch panel sensor according to claim 1, wherein the wire member comprises a flexible circuit board for electrically coupling the electrode patterns and an external main circuit.

12. The touch panel sensor according to claim 11, wherein:
the flexible circuit board is provided on the bottom surface of the insulating substrate along the window decoration and forms a circuit for electrically coupling upper and lower ends of the electrode patterns,
the flexible circuit board comprises connection terminals on one surface thereof, extending from the upper ends of the electrode patterns to the lower ends of the electrode patterns, in order to electrically couple the upper and lower ends of the electrode patterns, and
via holes each disposed close to an intersection point between the connection terminals are formed in the flexible circuit board, and the connection terminals are guided to another surface of the flexible circuit board through the via holes, thereby preventing the connection terminals from coming in contact with each other.

13. The touch panel sensor according to claim 1, wherein:
each of the coloration conduction layers comprises a plurality of individual membranes vertically piled, and
each of the individual membranes has a different mixing ratio of a conductive material and a non-conductive coloring material.

14. The touch panel sensor according to claim 13, wherein the ratio of the non-conductive coloring material to the conductive material is gradually increased toward a top surface of the insulating substrate.

15. The touch panel sensor according to claim 1, wherein the electrode patterns comprise:
first electrode patterns comprising a plurality of extension units provided in a row in one direction and a plurality of bridge units each coupling the plurality of extension units;
second electrode patterns formed in parallel to the first electrode patterns on an identical surface of the insulating substrate so that the second electrode patterns intersects the first electrode patterns, wherein the second electrode patterns are electrically separated from the first electrode patterns and the second electrode pattern comprises a plurality of transparent connection units formed in regions other than the extension units and the bridge units and a low resistance line coupling the transparent connection units over the bridge unit; and
an insulating pattern interposed between the bridge unit of the first electrode pattern and the low resistance line.

16. The touch panel sensor according to claim 1, further comprising an oxide layer interposed between the insulating substrate and the window decoration.
